# DEMANDE DE BREVET EUROPEEN

(11) **EP 2 315 213 A1**
(43) Date de publication de la demande: **27.04.2011**
(21) Numéro de dépôt: 10013505.2
(22) Date de dépôt: 11.10.2010
(51) Int. Cl.: G11C 16/24, G11C 16/26, G11C 7/12

(54) **Amplificateur de lecture ayant des moyens de précharge de ligne de bit rapides**

(30) Priorité: 20.10.2009 FR 0905037
(71) Demandeur: STMicroelectronics Rousset SAS, 13790 Rousset (FR)
(72) Inventeur: La Rosa, Francesco, 13790 Rousset (FR)
(74) Mandataire: Marchand, André

(57) **Abrégé**

L'invention concerne un amplificateur de lecture (SA4) comprenant un transistor cascode (TC) et des moyens pour polariser le transistor cascode, en fournissant une tension de contrôle (Vc) à une borne de grille du transistor cascode. Les moyens de polarisation du transistor cascode comprennent des moyens (SW1) pour isoler la borne de grille du transistor cascode de la sortie du générateur de tension (VG) lors d'une première période de la phase de précharge, afin de survolter la tension de ligne de bit, puis pour relier la borne de grille à la sortie du générateur de tension lors d'une seconde période de la phase de précharge. L'invention s'applique en particulier aux amplificateurs de lecture pour les mémoires non volatiles.

## Description

La présente invention concerne les amplificateurs de lecture, en particulier la lecture de cellules mémoire non volatiles, et plus particulièrement la gestion d'une phase de précharge de lignes de bit d'un plan mémoire, avant la lecture d'une cellule mémoire.

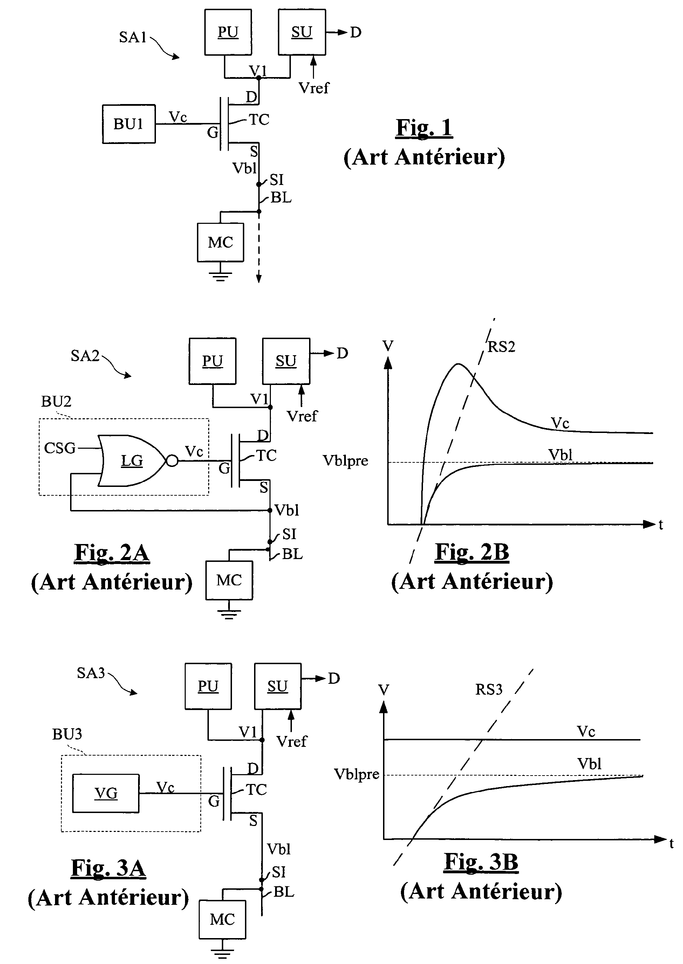

Les amplificateurs de lecture sont classiquement utilisés pour détecter l'état de cellules mémoire et pour fournir un signal de données fonction de cet état. La figure 1 représente schématiquement la structure d'un amplificateur de lecture SA1. L'amplificateur de lecture comprend une unité de lecture SU, une unité de précharge PU, un transistor cascode TC, une unité de polarisation BU1 et une entrée de lecture SI. Le transistor cascode TC comprend une borne de grille (G), une borne de drain (D) reliée à l'unité de lecture SU et à l'unité de précharge PU, et une borne de source (S) connectée à l'entrée de lecture SI. L'entrée de lecture SI est reliée, par l'intermédiaire d'une ligne de bit BL, à une cellule mémoire MC devant être lue.

La lecture de la cellule mémoire MC comprend une phase de précharge et une phase de lecture. Au début de la phase de précharge, l'unité de précharge PU applique une tension de précharge V1 à la borne de drain du transistor cascode TC et l'unité de polarisation BU1 applique une tension de contrôle Vc à la borne de grille du transistor cascode, qui devient conducteur. La borne de source (S) du transistor cascode TC fournit une tension de ligne de bit Vbl à la ligne de bit BL par l'intermédiaire de l'entrée de lecture SI. La tension Vbl augmente et atteint une tension de précharge de ligne de bit souhaitée. Puis, la tension de précharge V1 cesse d'être appliquée au transistor cascode, l'unité de lecture SU est activée et la phase de lecture commence. L'unité de lecture SU détecte l'état de la cellule mémoire MC et fournit une donnée (D) représentant l'état de la cellule mémoire.

Afin de réduire le temps de lecture et de minimiser le stress électrique sur les lignes de bit, la tension Vbl devrait être portée aussi vite que possible, lors de la phase de précharge, à la tension de précharge de ligne de bit, typiquement de 0,8 V ou moins. Deux modes de réalisation classiques de l'unité de polarisation sont représentés sur les figures 2A et 3B.

La figure 2A représente un amplificateur de lecture SA2 comprenant une unité de polarisation en boucle fermée BU2. L'unité de polarisation BU2 comprend une porte logique LG fournissant une tension de contrôle Vc à la borne de grille (G) du transistor cascode TC. La porte logique LG, par exemple une porte NON OU, est connectée à une entrée de la borne de source (S) du transistor cascode TC et reçoit sur une autre entrée un signal de contrôle CSG.

Au début de la phase de précharge, le signal de contrôle CSG passe de 1 à 0 et la tension de ligne de bit Vbl est basse. La sortie de la porte NON OU passe à 1, ce qui amène rapidement la tension de contrôle Vc à un niveau élevé, tel que représenté sur la figure 2B, activant ainsi le transistor cascode TC. Le transistor cascode commence à conduire et la tension de ligne de bit Vbl augmente, tel que représenté sur la figure 2B. Lorsque la tension Vbl atteint un point de déclenchement de la porte logique LG, celle-ci entre dans un état logique intermédiaire qui n'est ni 0 ni 1, provoquant la diminution de la tension de contrôle Vc. La diminution de la tension Vc fait diminuer la conductivité du transistor cascode, ralentissant ainsi le temps de montée de la tension de ligne de bit Vbl jusqu'à ce qu'elle atteigne la tension de précharge de ligne de bit Vblpre souhaitée.

La figure 3A représente un amplificateur de lecture SA3 comprenant une unité de polarisation en boucle ouverte BU3. L'unité de polarisation BU3 comprend un générateur de tension VG présentant une sortie reliée à la borne de grille du transistor cascode TC et fournissant la tension de contrôle Vc. Le générateur de tension VG applique la tension Vc à la borne de grille du transistor cascode TC au début de la phase de précharge, tel que représenté sur la figure 3B, mettant ainsi le transistor cascode TC dans l'état conducteur. La tension de ligne de bit Vbl augmente, tel que représenté sur la figure 3B, jusqu'à atteindre la tension de précharge de ligne de bit Vblpre souhaitée. La tension de contrôle doit être approximativement réglée à une valeur égale à Vblpre + Vt et par conséquent ne peut être très élevée. Pour cette raison, la tension de ligne de bit Vbl présente une pente montante RS3 qui est inférieure à la pente montante RS2 de la tension de ligne de bit Vbl de la figure 2B, obtenue avec l'unité de polarisation en boucle fermée BU2.

En résumé, l'unité de polarisation BU2 représentée sur la figure 2A permet une précharge de ligne de bit rapide. Cependant, la porte logique LG dans l'état logique intermédiaire présente une consommation statique de courant élevée car ses transistors de polarisation au niveau haut et au niveau bas sont tous les deux dans l'état conducteur, alors que l'unité de polarisation BU3 représentée sur la figure 3A présente une consommation de courant très faible.

Par conséquent, il peut être souhaité de prévoir un amplificateur de lecture présentant une unité de polarisation offrant un temps de précharge rapide ainsi qu'une faible consommation.

Des modes de réalisation de l'invention se rapportent à un amplificateur de lecture comprenant une unité de précharge fournissant une tension de précharge lors d'une phase de précharge, un générateur de tension présentant une sortie fournissant une tension de polarisation, un transistor cascode comprenant une borne de grille, une borne de drain recevant la tension de précharge, et une borne de source fournissant à l'entrée de lecture une tension de ligne de bit inférieure à la tension de précharge, et des moyens pour polariser le transistor cascode à l'aide de la tension de polarisation, fournissant une tension de contrôle à la borne de grille du transistor cascode, dans lequel les moyens de polarisation du transistor cascode comprennent au moins un condensateur grille-masse, un condensateur grille-source et un condensateur grille-drain pour le transistor cascode, et des moyens pour isoler la borne de grille du transistor cascode de la sortie du générateur de tension lors d'une première période de la phase de précharge, afin de survolter la tension de ligne de bit, puis pour relier la borne de grille à la sortie du générateur de tension lors d'une seconde période de la phase de précharge.

Selon un mode de réalisation, les moyens d'isolation de la borne de grille du générateur de tension comprennent un interrupteur.

Selon un mode de réalisation, les moyens d'isolation de la borne de grille du générateur de tension comprennent une résistance dont l'anode reçoit la tension de polarisation et dont la cathode est reliée à la borne de grille du transistor cascode, et un condensateur reliant l'anode de la résistance à la masse.

Selon un mode de réalisation, les moyens d'isolation de la borne de grille du générateur de tension comprennent un transistor à canal P présentant une borne de source recevant la tension de polarisation, une borne de drain connectée à la borne de grille du transistor cascode, et une borne de grille connectée à la masse, et un condensateur reliant la borne de source au transistor à canal P à la masse ou à une tension inférieure à la tension de polarisation.

Selon un mode de réalisation, au moins un élément parmi la groupe d'éléments comprenant le condensateur grille-masse, le condensateur grille-source et le condensateur grille-drain constitue ou comprend une capacité parasite du transistor cascode.

Des modes de réalisation de l'invention concernent également un plan mémoire comprenant au moins un amplificateur de lecture selon l'invention.

Des modes de réalisation de l'invention concernent également un circuit intégré sur une microplaquette de semi-conducteur, comprenant un plan mémoire comprenant au moins un amplificateur de lecture selon l'invention.

Des modes de réalisation de l'invention concernent également un dispositif portable comprenant un circuit intégré sur une microplaquette de semi-conducteur, le circuit intégré comprenant un plan mémoire comprenant au moins un amplificateur de lecture selon l'invention.

Des modes de réalisation de l'invention concernent également un procédé pour effectuer une phase de précharge sur une ligne de bit dans un plan mémoire avant de lire une cellule mémoire, mis en oeuvre à l'aide d'un amplificateur de lecture comprenant une unité de précharge fournissant une tension de précharge lors d'une phase de précharge, un générateur de tension présentant une sortie fournissant une tension de polarisation, et un transistor cascode comprenant une borne de grille, une borne de drain recevant la tension de précharge, et une borne de source fournissant à l'entrée de lecture une tension de ligne de bit inférieure à la tension de précharge, le procédé comprenant une étape consistant à polariser le transistor cascode à l'aide de la tension de polarisation, et à fournir une tension de contrôle à la borne de grille du transistor cascode, et, lors d'une première période de la phase de précharge, les étapes consistant à isoler la borne de grille du transistor cascode de la sortie du générateur de tension, afin de survolter la tension de ligne de bit, et, lors d'une seconde période de la phase de précharge, relier la borne de grille à la sortie du générateur de tension.

Selon un mode de réalisation, l'étape consistant à isoler la borne de grille de la sortie du générateur de tension est effectuée au moyen d'un interrupteur.

Selon un mode de réalisation, l'étape consistant à isoler la borne de grille de la sortie du générateur de tension est effectuée au moyen d'une résistance dont l'anode reçoit la tension de polarisation et dont la cathode est reliée à la borne de grille du transistor cascode, et d'un condensateur reliant l'anode de la résistance à la masse.

Selon un mode de réalisation, la résistance est un transistor à canal P configuré comme une résistance

Des modes de réalisation d'un amplificateur de lecture selon l'invention et ses applications seront exposés dans la description suivante faite à titre non limitatif en relation avec les figures jointes, parmi lesquelles :
- la figure 1 est le schéma de principe d'un amplificateur de lecture,
- la figure 2A représente un premier mode de réalisation classique d'un amplificateur de lecture,
- la figure 2B représente des courbes d'une tension de contrôle dans l'amplificateur de lecture de la figure 2A et d'une tension de ligne de bit fournie par l'amplificateur de lecture lors d'une phase de précharge,
- la figure 3A représente un second mode de réalisation classique d'un amplificateur de lecture,
- la figure 3B représente des courbes d'une tension de contrôle dans l'amplificateur de lecture de la figure 3A et d'une tension de ligne de bit fournie par l'amplificateur de lecture lors d'une phase de précharge,
- Les figures 4A, 4B, 4C représentent schématiquement différents modes de réalisation d'un amplificateur de lecture selon l'invention,
- la figure 5 représente des courbes d'une tension de contrôle dans l'amplificateur de lecture de la figure 4A, 4B ou 4C, et d'une tension de ligne de bit fournie par l'amplificateur de lecture lors d'une phase de précharge,
- la figure 6 représente plus en détails un mode de réalisation d'un amplificateur de lecture selon l'invention,
- la figure 7 représente une mémoire non volatile comprenant un amplificateur de lecture selon l'invention, et
- la figure 8 représente un dispositif portable comprenant une mémoire non volatile selon l'invention.

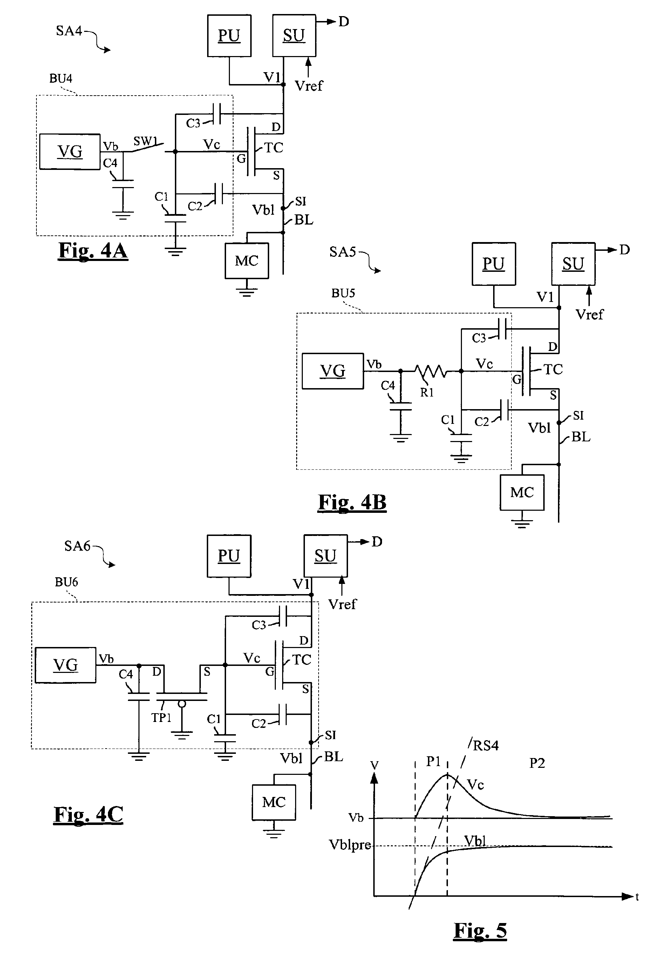

Différents modes de réalisation SA4, SA5, SA6 d'un amplificateur de lecture selon l'invention sont représentés sur les figures 4A, 4B, 4C. Chaque amplificateur de lecture comprend une unité de lecture SU, une unité de précharge PU, un transistor cascode TC, une unité de polarisation, respectivement BU4, BU5, BU6, et une entrée de lecture SI. Le transistor cascode TC comprend une borne de grille (G), une borne de drain (D) reliée à l'unité de lecture SU et à l'unité de précharge PU, et une borne de source (S) connectée à l'entrée de lecture SI. Lors du fonctionnement de l'amplificateur de lecture, l'entrée de lecture SI est reliée, par l'intermédiaire d'une ligne de bit BL, à une cellule mémoire MC pour être détectée.

Comme indiqué ci-dessus, la détection de la cellule mémoire MC comprend une phase de précharge et une phase de lecture. Lors de la phase de précharge, l'unité de précharge PU applique une tension de précharge V1 à la borne de drain du transistor cascode TC et l'unité de polarisation BU4, BU5, BU6 applique une tension de contrôle Vc à la borne de grille du transistor cascode. La borne de source (S) du transistor cascode TC fournit une tension de ligne de bit Vbl à la ligne de bit BL par l'intermédiaire de l'entrée de lecture SI. La tension de ligne de bit atteint une tension de précharge de ligne de bit Vblpre souhaitée. Puis, la tension de précharge V1 cesse d'être appliquée au transistor cascode, l'unité de lecture SU est activée et la phase de lecture commence. L'unité de lecture SU détecte l'état de la cellule mémoire MC et fournit une donnée (D) représentant l'état de la cellule mémoire, par exemple 0 si la cellule mémoire est dans un état conducteur et 1 si la cellule mémoire n'est pas dans l'état conducteur ou dans un état moins conducteur.

Dans le mode de réalisation représenté sur la figure 4A, l'unité de polarisation BU4 comprend un générateur de tension VG, un interrupteur SW1, et des condensateurs C1, C2, C3 et C4. Le générateur de tension VG présente une sortie reliée à la masse par l'intermédiaire du condensateur C4 fournissant une tension de polarisation Vb. La borne de grille du transistor cascode TC est reliée à la sortie du générateur de tension VG par l'intermédiaire de l'interrupteur SW1. Le condensateur C1 est connecté entre la borne de grille du transistor cascode TC et la masse. Le condensateur C2 est connecté entre la borne de grille et la borne de source du transistor cascode TC. Le condensateur C3 est connecté entre la borne de grille et la borne de drain du transistor cascode TC. Les condensateurs C1, C2, C3 sont par exemple de plusieurs femtofarads.

Il est à noter que chaque condensateur C1, C2 ou C3 peut être un composant fourni par le concepteur du circuit, ou une capacité parasite du transistor cascode TC (respectivement des capacités parasites grille-masse, grille-source ou grille-drain) ou une combinaison d'un composant prévu par le concepteur et d'une capacité parasite.

La figure 5 représente des courbes d'une tension de contrôle Vc et d'une tension de ligne de bit Vbl lors d'une phase de précharge. La phase de précharge comprend une première période P1 lors de laquelle l'interrupteur est mis dans l'état ouvert et une seconde période P2 lors de laquelle l'interrupteur est mis dans l'état fermé. Il est supposé que l'interrupteur SW1 a été mis dans l'état fermé lors d'une période d'initialisation, de telle sorte que la tension de contrôle Vc est présente sur la borne de grille du transistor cascode TC lorsque la première période P1 de la phase de précharge débute, et le transistor TC est dans l'état conducteur.

Au début de la première période, l'interrupteur SW1 est ouvert et la tension de précharge V1 est appliquée sur la borne de drain du transistor TC. La borne de grille du transistor TC devient flottante. La tension de ligne de bit Vbl est tirée vers le haut car le transistor TC est dans l'état conducteur et augmente rapidement avec une pente montante abrupte RS4. Également, la tension de contrôle Vc est rapidement tirée vers le haut et augmente rapidement car le transistor TC a sa borne de grille couplée à sa borne de drain par le condensateur C3, et couplée à sa borne de source par le condensateur C2. Cependant, le condensateur C1 se charge graduellement et empêche la tension de contrôle Vc d'augmenter trop abruptement.

Au début de la seconde période P2, qui est déclenchée lorsque la tension de ligne de bit Vbl est fermée à la tension de précharge Vblpre souhaitée, l'interrupteur SW1 est à nouveau fermé et la tension de polarisation Vb tire la tension de contrôle Vc vers le bas jusqu'à ce qu'elle soit à nouveau égale à Vb. Le condensateur C1 se décharge et empêche la tension de contrôle Vc de diminuer trop abruptement.

En résumé, ce mode de réalisation fournit un effet d'accélération similaire à celui obtenu par l'unité de polarisation classique à boucle fermée BU2 représentée sur la figure 2A, avec l'avantage d'une faible consommation de courant offerte par l'unité de polarisation à boucle ouverte BU3 représentée sur la figure 3A, grâce à un mécanisme de couplage capacitif.

L'unité de polarisation BU5 représentée sur la figure 4B fournit des avantages équivalents à l'aide de l'interrupteur SW1 et par conséquent sans avoir à appliquer un signal de contrôle à cet interrupteur. La borne de grille du transistor cascode TC est reliée à la sortie du générateur de tension VG par l'intermédiaire d'une résistance R1, qui remplace l'interrupteur SW1. La résistance R1 présente une valeur élevée et peut être d'environ quelques kilohms.

Le fonctionnement de l'amplificateur de lecture SA5 lors de la phase de précharge est également représenté sur la figure 5 et la phase de précharge comprend une première période et une seconde période P1, P2. Au début de la première période P1, la tension de contrôle Vc est présente sur la borne de grille du transistor cascode TC lorsque la tension de précharge V1 est appliquée sur la borne de drain du transistor cascode TC. La tension de ligne de bit Vbl est tirée vers le haut car le transistor TC est dans l'état conducteur et augmente rapidement. Puisque la borne de grille du transistor cascode est reliée aux bornes de drain et de source du transistor par les condensateurs C3 et C2, la tension de contrôle Vc est également tirée vers le haut et augmente rapidement alors que la résistance R1 isole temporairement la borne de grille de la sortie du générateur de tension VC. Lors de la seconde période de la phase de précharge, le condensateur C3 se charge et la tension Vc est graduellement tirée vers le bas par la tension Vb par l'intermédiaire de la résistance R1, jusqu'à ce qu'elle devienne égale à Vb.

Ce mode de réalisation fournit également un effet d'accélération similaire à celui obtenu par l'unité de polarisation classique à boucle fermée BU2 représentée sur la figure 2A, avec l'avantage d'une faible consommation de courant offerte par l'unité de polarisation à boucle ouverte BU1 représentée sur la figure 3A, grâce à un mécanisme de couplage capacitif mettant en jeu les condensateurs C1, C2, C3.

L'unité de polarisation BU6 représentée sur la figure 4C est identique à celle de la figure 4B à l'exception de la résistance R1 qui est remplacée par un transistor TP1 à canal P configuré comme une résistance. Le transistor TP1 a sa borne de source (S) connectée à la borne de grille du transistor cascode TC, sa borne de drain (D) connectée à la sortie du générateur de tension VG, et sa borne de grille (G) connectée à la masse ou à une tension suffisamment basse par rapport à la tension de polarisation Vb pour que le transistor TP1 fonctionne comme une résistance. Alternativement, le transistor TP1 peut être un transistor à canal N dont la borne de grille est connectée à une tension supérieure à la tension de polarisation Vb.

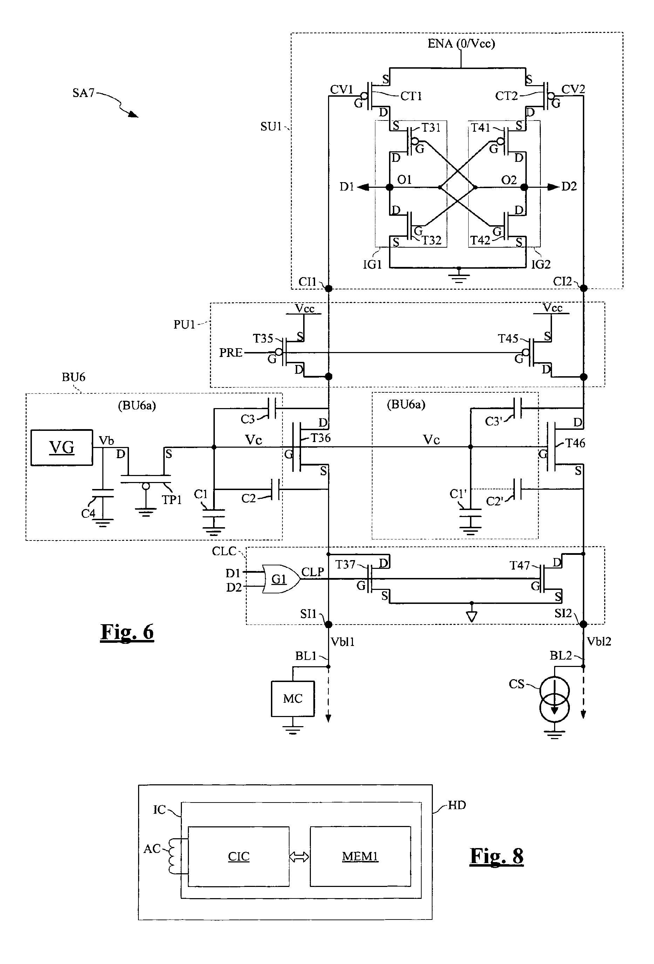

Un amplificateur de lecture SA7 selon un mode de réalisation de l'invention est représenté sur la figure 6. L'amplificateur de lecture SA7 est alimenté électriquement par une tension d'alimentation Vcc et présente une première entrée de lecture SI1 et une seconde entrée de lecture SI2. La première entrée de lecture SI1 est reliée à une cellule mémoire MC par l'intermédiaire d'une ligne de bit BL1. La seconde entrée de lecture SI2 est connectée à une ligne de référence BL2 reliée à une source de courant CS ou à tout autre élément de référence tel qu'une résistance de référence. Alternativement, la seconde entrée de lecture SI2 peut être reliée à une cellule mémoire MC par l'intermédiaire d'une ligne de bit, et la première entrée de lecture SI1 peut être reliée à une ligne de référence reliée à une source de courant ou un autre élément de référence.

L'amplificateur de lecture SA7 comprend une unité de lecture SU1 comprenant une première section IG1, une seconde section IG2 couplée à la première section IG1, un premier noeud de sortie O1 et un second noeud de sortie O2. La première section IG1 présente une sortie connectée au noeud de sortie O1 et fournit un signal de données logique D1. La seconde section IG2 présente une sortie connectée au noeud de sortie O2 et fournit un signal de données logique D2. Chaque section IG1, IG2 est alimentée électriquement par un signal d'activation ENA qui est amené à la tension Vcc (ENA=1) lorsque l'unité de lecture doit être activée et qui est mise à la masse (ENA₌0) lorsque l'unité de lecture doit être désactivée. Des moyens pour forcer à 0 des signaux de données D1, D2 lorsque le signal d'activation ENA est égal à 0 peuvent également être prévus, par exemple des transistors à canal N connectés entre les sorties O1, O2 (non représentées) et la masse et contrôlés par un signal /ENA qui est égal à Vcc lorsque ENA est égal à 0, et vice-versa.

Le signal d'alimentation ENA, c'est-à-dire la tension d'alimentation Vcc lorsque ENA=1, est appliqué à la première section IG1 par l'intermédiaire d'un premier transistor de contrôle CT1 à canal P, et est appliqué à la seconde section IG2 par l'intermédiaire d'un second transistor de contrôle CT2 à canal P. La borne de grille (G) du transistor cascode CT1 forme une première entrée de contrôle CI1 de l'unité de lecture SU1 et est reliée à la première entrée de lecture SI1 de l'amplificateur de lecture SA7. La borne de grille (G) du transistor CT2 forme une seconde entrée de contrôle CI2 de l'unité de lecture et est reliée à la seconde entrée de lecture SI2 de l'amplificateur de lecture SA7.

La première entrée de contrôle CI1 de l'unité de lecture est reliée à la première entrée de lecture SI1 par l'intermédiaire d'un transistor cascode T36 à canal N et la seconde entrée de contrôle CI2 de l'unité de lecture est reliée à la seconde entrée de lecture SI2 par un transistor cascode T46 à canal N. Les transistors cascode T36, T46 sont contrôlés par une tension de contrôle Vc appliquée sur leur borne de grille et fournie par l'unité de polarisation BU6 précédemment décrite en relation avec la figure 4, qui comprend ici deux sections BU6a, BU6b. La section BU6a comprend des condensateurs C1, C2, C3, par exemple les capacités parasites du transistor T36, et comprend le transistor TP1, le condensateur C4, et le générateur de tension VG. La section BU6b comprend des condensateurs C1', C2', C3', par exemple les capacités parasites du transistor T46.

La première section et la seconde section IG1, IG2 de l'unité de lecture sont par exemple des portes inverseuses en couplage croisé, l'entrée de la porte IG1 état connectée à la sortie de la porte IG2 et vice-versa. La porte inverseuse IG1 comprend par exemple un transistor T31 à canal P et un transistor T32 à canal N ayant leurs bornes de drain (D) connectées au noeud de sortie O1 et leurs bornes de grille (G) connectées au noeud de sortie O2. La borne de source (S) du transistor T32 est connectée à la masse et la borne de source (S) du transistor T31 est connectée à la borne de drain (D) du transistor de contrôle CT1, dont la borne de source (S) reçoit l'alimentation et le signal d'activation ENA. De même, la porte inverseuse IG2 comprend par exemple un transistor T41 à canal P et un transistor T42 à canal N ayant leurs bornes de drain (D) connectées au noeud de sortie O2 et leurs bornes de grille (G) connectées au noeud de sortie O1. La borne de source (S) du transistor T42 est connectée à la masse et la borne de source (S) du transistor T41 est connectée à la borne de drain (D) du transistor de contrôle CT2, dont la borne de source (S) reçoit l'alimentation et le signal d'activation ENA.

L'amplificateur de lecture SA7 comprend en outre une unité de précharge PU1 comprenant des transistors de précharge T35, T45 à canal P. Chaque transistor de précharge T35, T45 a sa borne de drain (D) connectée à une entrée de contrôle de l'unité de lecture, respectivement CI1, CI2, reçoit la tension Vcc sur sa borne de source (S), et un signal de précharge PRE sur sa borne de grille (G).

L'amplificateur de lecture SA7 comprend également un circuit de verrouillage CLC. Le circuit de verrouillage CLC comprend deux transistors T37, T47 à canal N. Chaque transistor T37, T47 a sa borne de drain (D) connectée à une entrée de lecture SI1, SI2 respectivement, sa borne de source (S) connectée à la masse, et reçoit un signal de verrouillage CLP sur sa borne de grille (G).

Dans un mode de réalisation, le signal de verrouillage CLP est automatiquement activé lorsque l'un des premier et second signaux de données D1, D2 augmente et atteint une tension de seuil. Le signal de verrouillage CLP est par exemple fourni par une porte OU G1 qui reçoit les premier et second signaux de données D1, D2, en entrée.

Comme indiqué précédemment, la seconde entrée de lecture SI2 est reliée à la source de courant CS par l'intermédiaire de la ligne de référence BL2. Il est supposé que la source de courant CS tire un courant constant dont la valeur est réglée entre la valeur d'un courant passant par une cellule mémoire dans l'état de conductivité haute et la valeur d'un courant passant par une cellule mémoire dans l'état de conductivité basse.

La phase de précharge débute lorsque le signal PRE est réglé sur zéro de telle sorte que les transistors T35, T45 à canal P deviennent conducteurs. La tension de contrôle Vc est appliquée sur la borne de grille des transistors T36, T46 en fonction de la première période et de la seconde période décrites ci-dessus en relation avec la figure 5. Il en résulte que les tensions de lignes de bit Vb11 et Vb12 commencent à augmenter jusqu'à ce qu'elles atteignent une tension de précharge de ligne de bit Vblpre approximativement égale à Vc-Vgs, Vgs étant la tension grille-source des transistors T36, T46. Les tensions de contrôle CV1, CV2 sur les entrées de contrôle CI1, CI2 augmentent également et atteignent une tension égale à Vcc. Il est supposé que le signal d'activation ENA a précédemment été mis à zéro de telle sorte que l'unité de lecture SU1 est désactivée lors de la phase de précharge et que ses noeuds de sortie O1, O2 sont dans l'état HZ (haute impédance).

L'amplificateur de lecture SA7 entre en phase de lecture lorsque le signal de précharge PRE retourne à 1 afin de désactiver les transistors T35, T45. Approximativement au même moment, le signal d'activation ENA est mis à 1 (Vcc). Comme elles ne sont plus en train d'être chargées, la ligne de bit BL1 et la ligne de référence BL2 commencent à se décharger. Les tensions de lignes de bit Vb11, Vb12 commencent à diminuer à partir de Vc-Vgs et les tensions de contrôle CV1, CV2 commencent à diminuer à partir de Vcc.

Si la cellule mémoire MC est en état de conductivité basse, le courant passant dans la cellule mémoire est inférieur au courant de référence tiré par la source de courant. Par conséquent, la ligne de référence BL2 se décharge plus rapidement que la ligne de bit BL1, et la tension Vb12 diminue plus rapidement que la tension Vb11. La différence de tension entre Vb11, Vb12 est amplifiée par les transistors cascode T36, T46 et une différence de tension plus importante apparaît entre les tensions de contrôle CV1, CV2. La tension CV2 diminue plus rapidement que la tension CV1.

Si la cellule mémoire MC est dans l'état de conductivité haute, le courant passant par la cellule mémoire est supérieur au courant de référence tiré par la source de courant. Par conséquent, la ligne de bit BL1 se décharge plus rapidement que la ligne de référence BL2, et la tension Vb11 diminue plus rapidement que la tension Vb12. La différence de tension entre Vb11, Vb12 est amplifiée par les transistors cascode T36, T46 et la tension CV1 diminue plus rapidement que la tension CV2.

Dans les deux cas, la tension CV1 ou CV2 qui diminue le plus rapidement atteint une tension de seuil Vth telle que le transistor correspondant CT1 ou CT2 devient conducteur. Les transistors CT1 et CT2 étant du type P et l'unité de lecture étant alimentée par la tension Vcc (fournie en tant que signal d'activation ENA), une telle tension de seuil Vth est ici égale à Vcc-Vtp, Vtp étant la tension de seuil des transistors CT1, CT2 à canal P.

Par exemple, si la tension CV2 est la première à atteindre la tension de seuil Vth, le transistor de contrôle CT2 est le premier à devenir conducteur. Par conséquent, le transistor CT2 passe la tension Vcc à la porte inverseuse IG2, et le signal de données D2 sur le noeud de sortie O2 commence à augmenter. Puis, le signal D2 atteint une valeur de seuil VtOR de la porte OU G1 et le signal de verrouillage CLP passe de 0 à 1 (Vcc). Lorsque le signal de verrouillage atteint une tension de seuil Vtn des transistors à canal N T37, T47, ce dernier devient passant et connecte la première et la seconde entrées de lecture SI1, SI2 à la masse. Les tensions de lignes de bit Vb11, Vb12, ainsi que les tensions de contrôle CV1, CV2 sont tirées vers la masse, qui met les deux transistors de contrôle à canal P CT1, CT2 dans l'état complètement conducteur. L'unité de lecture devient complètement opérationnelle et verrouille les valeurs provisoires des signaux de données D1 et D2, c'est-à-dire D1=0 et D2=1 dans cet exemple, qui deviennent les valeurs de données verrouillées finales pour la phase de lecture actuelle.

Il sera noté que grâce à l'utilisation de la borne de grille des transistors de contrôle CT1, CT2 comme "moyens de détection" en combinaison avec l'alimentation de l'unité de lecture par de tels transistors, on n'a plus besoin des transistors d'isolation, qui sont nécessaires dans l'art antérieur pour déconnecter les entrées du verrou à partir des entrées de lecture lors de la phase de lecture, afin d'échantillonner la différence de tension entre l'entrée de lecture sans que les noeuds de sortie de l'unité de lecture interagissent avec la ligne de bit détectée.

D'autre part, l'utilisation des valeurs provisoires des signaux de données D1, D2 pour activer le circuit de verrouillage CLP, lequel en retour rend l'unité de lecture complètement opérationnelle pour le verrouillage les valeurs provisoires de D1, D2, rend l'amplificateur de lecture SA7 "auto-minuté". Cependant, des modes de réalisation où le signal de verrouillage est activé par des moyens non auto-minutés peuvent être prévus, par exemple une minuterie qui se déclenche lorsque la phase de lecture débute.

De plus, il sera noté que des modes de réalisation d'un amplificateur de lecture selon l'invention peuvent comprendre différents autres types de moyens de précharge et des moyens de verrouillage différents de ceux qui ont été décrits ci-dessus. De plus, les première et seconde sections IG1, IG2 du verrou sont susceptibles de divers autres modes de réalisation et peuvent comprendre, par exemple, d'autres portes logiques telles que des portes NON-ET, des portes NON-OU, des transistors en série ou en parallèle, etc., en fonction de ce que souhaite l'homme de l'art désirant mettre en oeuvre l'invention conformément à la présente description.

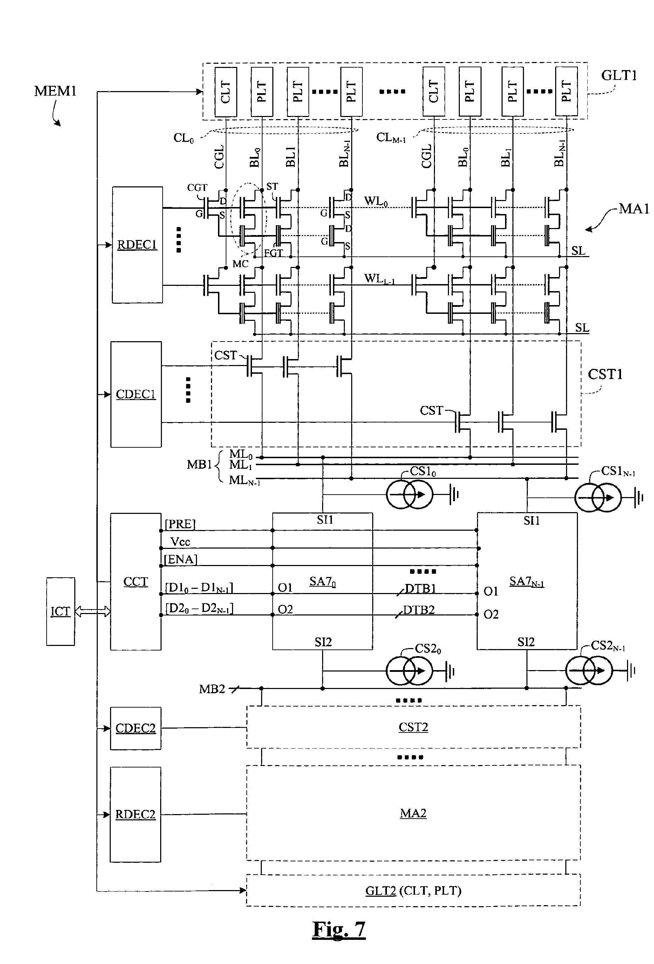

La figure 7 représente un exemple d'application dans lequel une série d'amplificateurs de lecture selon l'invention est incorporée dans un dispositif à mémoire non volatile effaçable et programmable électriquement MEM1. Le dispositif à mémoire MEM1 comprend deux plans mémoire MA1, MA2. Le plan mémoire MA2, représenté sous forme de bloc, présente la même structure que le plan mémoire MA1. Chaque plan mémoire MA1, MA2 comprend L lignes de mot WL (WL₀-WL_{L-1}) et M colonnes CL (CL₀-CL_{M-1}) . Chaque colonne CL comprend N lignes de bit BL (BL₀-BL_{N-1}) et une ligne de grille de contrôle CGL. Chaque plan mémoire MA1, MA2 comprend L*M*N cellules mémoires MC. Dans cet exemple, les plans mémoire MA1, MA2 sont effaçables par mot et programmables par mot, un mot comprenant des cellules mémoire de la même colonne connectées à la même ligne de mot.

Chaque cellule mémoire MC d'un mot comprend un transistor de sélection ST et un transistor à grille flottante FGT. Le transistor de sélection ST a sa borne de drain (D) connectée à une ligne de bit BL, sa borne de source (S) connectée à la borne de drain (D) du transistor à grille flottante, et sa borne de grille (G) connectée à une ligne de mot WL. Le transistor à grille flottante FGT a sa borne de source (S) connectée à une ligne de source SL et sa borne de grille (G) connectée à la borne de source (S) d'un transistor à grille de contrôle CGT. Le transistor à grille de contrôle CGT a sa borne de grille (G) connectée à la ligne de mot considérée et sa borne de drain (D) connectée à la ligne de grille de contrôle CGL de la colonne considérée.

Le dispositif à mémoire MEM1 comprend en outre un premier et un second décodeurs de rangée RDEC1, RDEC2, un premier et un second décodeurs de colonne CDEC1, CDEC2, un premier et un second groupes GLT1, GLT2 de verrous de colonne CLT et de verrous de programmation PLT, un premier et un second groupes CST1, CST2 de transistors de sélection de colonne CST, un premier et un second bus de multiplexage MB1, MB2, une rangée centrale de N amplificateurs de lecture SA7 (SA7₀-SA7_{N-1}) selon l'invention, et un circuit de contrôle central CCT tel qu'un microprocesseur, un séquenceur microprogrammé, ou une machine d'état recevant des commandes et des données de l'extérieur et fournissant des réponses et des données à l'extérieur par l'intermédiaire d'un circuit d'interface de communication ICT.

Le décodeur de rangée RDEC1 fournit des signaux de sélection de rangée aux lignes de mots WL (WL₀-WL_{L-1}) du plan mémoire MA1 et le décodeur de rangée RDEC2 fournit des signaux de sélection de rangée aux lignes de mots du plan mémoire MA2. Le décodeur de colonne CDEC1 fournit des signaux de sélection de colonne aux transistors de sélection de colonne CST du groupe CST1 et le décodeur de colonne CDEC2 fournit des signaux de sélection de colonne aux transistors de sélection de colonne du groupe CST2.

Les lignes de bit du plan mémoire MA1 appartenant à différentes colonnes et présentant le même rang ou le même poids (c'est-à-dire stockant des bits de même rang des différents mots) sont reliées à l'entrée de lecture SII du même amplificateur de lecture SA7 par l'intermédiaire des transistors de sélection de colonne CST du groupe CST1 et du bus de multiplexage MB1. De même, les lignes de bit du plan mémoire MA2 appartenant à différentes colonnes et présentant le même rang ou le même poids sont reliées à l'entrée de lecture SI2 du même amplificateur de lecture SA7 par l'intermédiaire des transistors de sélection de colonne du groupe CST2 et du bus de multiplexage MB2. Par exemple, les lignes de bit BL₀ des colonnes CL₀ à CL_{M-1} sont reliées à l'amplificateur de lecture SA7₀ par l'intermédiaire de transistors CST et d'une ligne ML₀ du bus de multiplexage MB1. Les lignes de bit BL_{N-1} des colonnes CL₀ à CL_{M-1} sont reliées à l'amplificateur de lecture SA7_{N-1} par l'intermédiaire des transistors CST et d'une ligne ML_{N-1} du bus de multiplexage MB1.

Le circuit de contrôle CCT fournit le signal de précharge PRE et le signal d'activation ENA décrits ci-dessus aux amplificateurs de lecture SA7₀-SA7_{N-1}. Les sorties O1 des amplificateurs de lecture SA7₀-SA7_{N-1} sont connectées à différentes lignes d'un bus de données DTB1 et les sorties O2 sont connectées à différentes lignes d'un bus de données DTB2.

Enfin, chaque entrée de lecture SII de chaque amplificateur de lecture SA7₀ à SA7_{N-1} est reliée à une source de courant CS1₀ à CS1_{N-1} par l'intermédiaire d'une ligne de référence et chaque entrée de lecture SI2 de chaque amplificateur de lecture SA7₀ à SA7_{N-1} est reliée à une source de courant CS2₀ à CS2_{N-1} par l'intermédiaire d'une ligne de référence. Chaque source de courant CS1, CS2 est agencée entre l'entrée de lecture et les lignes de multiplexage, mais peut également être connectée à une ligne de bit à laquelle l'entrée de lecture considérée est reliée par l'intermédiaire du bus de multiplexage.

Des étapes de programmation et d'effacement de cellules mémoire ne seront pas décrites en détails et sont effectuées par le circuit de contrôle CCT, qui contrôle les décodeurs RDEC1, RDEC2, CDEC1, CDEC2 et leur fournit des adresses de rangée et de colonne reçues par l'intermédiaire de l'interface ICT, ainsi que des signaux de contrôle et une tension de programmation ou d'effacement Vpp. Le circuit de contrôle CCT fournit également aux verrous de programmation des données reçues par l'intermédiaire de l'interface ICT, et les verrous de colonne sont sélectionnés et activés par les signaux de sélection de colonne fournis par le décodeur de colonne CDEC1. L'effacement d'un mot comprend des étapes consistant à appliquer la tension Vpp sur la ligne de mot correspondant, par l'intermédiaire d'un décodeur de rangée RDEC1 ou RDEC2, et appliquer la tension Vpp sur la ligne de grille de contrôle correspondante CGL par l'intermédiaire du verrou de colonne correspondant CLT alors que la ligne de source correspondante est connectée à la masse. La programmation des cellules mémoire comprend des étapes consistant à appliquer la tension Vpp aux lignes de bit correspondantes par l'intermédiaire des verrous de programmation correspondants, appliquer la tension Vpp à la ligne de mot correspondante, et connecter à la masse la ligne de grille de contrôle correspondante CGL par l'intermédiaire du verrou de colonne correspondant.

Une étape de lecture des cellules mémoire est effectuée par le circuit de contrôle CCT au moyen des amplificateurs de lecture SA7, et comprend l'activation des sources de courant du plan mémoire opposé au plan mémoire dans lequel les cellules mémoire à lire sont situées, puis la précharge des lignes de bit et la lecture du signal de données D1 ou D2 sur le bus de données correspondant DTB1 ou DTB2. Par exemple, si des cellules mémoire dans le plan mémoire MA1 doivent être lues, le circuit de contrôle CCT sélectionne d'abord la ligne de mot correspondante au moyen du décodeur de rangée RDEC1, et connecte les N lignes de bit de la colonne concernée aux amplificateurs de lecture SA7₀ à SA7_{N-1} au moyen du décodeur de colonne CDEC1 et par l'intermédiaire des transistors de sélection de colonne CST du groupe CST1. Le circuit CCT active ensuite les sources de courant CS2 dans le plan mémoire MA2, applique le signal de précharge PRE et active le générateur de tension VG, et applique le signal d'activation ENA de la façon décrite ci-dessus aux amplificateurs de lecture SA7, lit les données D1 sur le bus de données DTB1 (chaque amplificateur de lecture fournit un bit d'un mot Dlₒ à Dan-1) puis les fournit à l'extérieur par l'intermédiaire de l'interface ICT.

Il sera noté que cet exemple de réalisation d'un dispositif à mémoire utilisant des amplificateurs de lecture selon l'invention a été décrit à titre d'exemple non limitatif. Des modes de réalisation d'amplificateurs de lecture selon l'invention peuvent être mis en oeuvre dans divers types d'architectures de mémoire, et peuvent être utilisés dans toute application dans laquelle l'état d'une cellule mémoire peut être déterminé en détectant une chute de tension sur les bornes de la cellule mémoire. Des amplificateurs de lecture SA7 peuvent également être utilisés dans des dispositifs à mémoire ne présentant pas un plan mémoire dual tel que décrit ci-dessus. Dans ce cas, la seconde entrée de lecture SI2 est connectée à une ligne de référence qui n'est pas reliée à des lignes de bit du plan mémoire. Alternativement, l'amplificateur de lecture peut être de type asymétrique avec une source de courant interne.

Un dispositif à mémoire comprenant des amplificateurs de lecture selon l'invention est également susceptible de nombreux modes de réalisation et de nombreuses applications. Par exemple, la figure 8 représente schématiquement un dispositif portable HD comprenant un circuit intégré IC dans lequel la mémoire MEM1 décrite ci-dessus ou tout autre type de mémoire non volatile comprenant des amplificateurs de lecture selon l'invention est intégrée. Dans un mode de réalisation, le dispositif portable HD peut être une carte à puce sans contact, une étiquette, un téléphone portable, un PDA, etc., et peut comprendre un circuit d'interface de communication sans contact CIC auquel la mémoire MEM1 est connectée. Le circuit d'interface CIC peut être un circuit d'interface NFC (Near Field Communication) connecté à une bobine d'antenne AC, configuré pour échanger des données par couplage inductif et modulation de charge, ou peut être un circuit d'interface UHF (Ultra High Frequency) connecté à une antenne UHF (non représentée) et configuré pour échanger des données par couplage électrique et rétrodiffusion. Le dispositif portable HD peut être configuré pour communiquer avec un dispositif externe tel qu'une carte ou un lecteur d'étiquette sans contact, un point de vente, un autre téléphone portable NFC, etc. La mémoire MEM1 peut être utilisée à la fois pour stocker du code (en particulier des programmes d'application) et des données d'applications.

## Revendications

1. Amplificateur de lecture comprenant :
- une unité de précharge (PU) fournissant une tension de précharge (V1) lors d'une phase de précharge,
- un générateur de tension (VG) présentant une sortie fournissant une tension de polarisation (V1),
- un transistor cascode (TC) comprenant une borne de grille (G), une borne de drain (D) recevant la tension de précharge (V1), et une borne de source (S) fournissant à l'entrée de lecture une tension de ligne de bit (Vbl) inférieure à la tension de précharge (V1), et
- des moyens pour polariser le transistor cascode à l'aide de la tension de polarisation (V1), fournissant une tension de contrôle (Vc) à la borne de grille du transistor cascode,
**caractérisé en ce que** les moyens de polarisation du transistor cascode comprennent :
- au moins un condensateur grille-masse (C1), un condensateur grille-source (C2) et un condensateur grille-drain (C3) pour le transistor cascode, et
- des moyens (SW1, R1, TP1, C4) pour isoler la borne de grille du transistor cascode de la sortie du générateur de tension (VG) lors d'une première période de la phase de précharge, afin de survolter la tension de ligne de bit, puis pour relier la borne de grille à la sortie du générateur de tension lors d'une seconde période de la phase de précharge.

2. Amplificateur de lecture selon la revendication 1, dans lequel les moyens d'isolation de la borne de grille du générateur de tension comprennent un interrupteur (SW1).

3. Amplificateur de lecture selon la revendication 1, dans lequel les moyens d'isolation de la borne de grille du générateur de tension comprennent :
- une résistance (R1) dont l'anode reçoit la tension de polarisation (Vb) et dont la cathode est reliée à la borne de grille du transistor cascode, et
- un condensateur (C4) reliant l'anode de la résistance à la masse.

4. Amplificateur de lecture selon l'une des revendications 1 à 3, dans lequel les moyens d'isolation de la borne de grille du générateur de tension comprennent :
- un transistor à canal P (TP1) présentant une borne de source recevant la tension de polarisation, une borne de drain connectée à la borne de grille du transistor cascode, et une borne de grille connectée à la masse, et
- un condensateur (C4) reliant la borne de source au transistor à canal P à la masse ou à une tension inférieure à la tension de polarisation.

5. Amplificateur de lecture selon l'une des revendications 1 à 4, dans lequel au moins un élément parmi le groupe d'élément comprenant le condensateur grille-masse (C1), le condensateur grille-source (C2) et le condensateur grille-drain (C3) constitue ou comprend une capacité parasite du transistor cascode.

6. Plan mémoire comprenant au moins un amplificateur de lecture selon l'une des revendications 1 à 5.

7. Circuit intégré sur une microplaquette de semi-conducteur, comprenant un plan mémoire comprenant au moins un amplificateur de lecture selon l'une des revendications 1 à 5.

8. Dispositif portable comprenant un circuit intégré sur une microplaquette de semi-conducteur, le circuit intégré comprenant un plan mémoire comprenant au moins un amplificateur de lecture selon l'une des revendications 1 à 5.

9. Procédé pour effectuer une phase de précharge sur une ligne de bit dans un plan mémoire avant de lire une cellule mémoire, mis en oeuvre à l'aide d'un amplificateur de lecture comprenant :
- une unité de précharge (PU) fournissant une tension de précharge (V1) lors d'une phase de précharge,
- un générateur de tension (VG) présentant une sortie fournissant une tension de polarisation (V1), et
- un transistor cascode (TC) comprenant une borne de grille (G), une borne de drain (D) recevant la tension de précharge (V1), et une borne de source (S) fournissant à l'entrée de lecture une tension de ligne de bit (Vbl) inférieure à la tension de précharge (V1),
le procédé comprenant une étape consistant à polariser le transistor cascode à l'aide de la tension de polarisation (V1), et à fournir une tension de contrôle (Vc) à la borne de grille du transistor cascode,
**caractérisé en ce qu'**il comprend en outre des étapes consistant à _{:}
- lors d'une première période de la phase de précharge, isoler la borne de grille du transistor cascode de la sortie du générateur de tension (VG), afin de survolter la tension de ligne de bit, et
- lors d'une seconde période de la phase de précharge, relier la borne de grille à la sortie du générateur de tension.

10. Procédé selon la revendication 9, dans lequel l'étape consistant à isoler la borne de grille de la sortie du générateur de tension (VG) est effectuée au moyen d'un interrupteur (SW1).

11. Procédé selon la revendication 9, dans lequel l'étape consistant à isoler la borne de grille de la sortie du générateur de tension (VG) est effectuée au moyen d'une résistance (R1) dont l'anode reçoit la tension de polarisation (Vb) et dont la cathode est reliée à la borne de grille du transistor cascode, et d'un condensateur (C4) reliant l'anode de la résistance à la masse.

12. Procédé selon la revendication 9, dans lequel la résistance est un transistor à canal P (TP1) configuré comme une résistance.
